# EUROPEAN PATENT SPECIFICATION

(11) **EP 1 400 860 B1**
(45) Date of publication and mention of the grant of the patent: **06.11.2013**
(21) Application number: 03077976.3
(22) Date of filing: 19.09.2003
(51) Int. Cl.: G03F 9/00

(54) **Lithographic marker structure, lithographic projection apparatus comprising such a lithographic marker structure and method for substrate alignment using such a lithographic marker structure**
Lithographische Markierungsstruktur, lithographischer Projektionsapparat mit einer solchen Markierungsstruktur und Verfahren zur Ausrichtung eines Substrates unter Verwendung einer solchen Markierungsstruktur
Structure d'une marque lithograhique, appareil de projection lithographique comprenant une telle structure et procédé d'alignement d'un substrat utilisant une telle structure

(30) Priority: 20.09.2002 US 411861 P; 26.09.2002 US 413601 P; 01.04.2003 EP 03075954; 12.05.2003 EP 03076422
(43) Date of publication of application: 24.03.2004
(60) Divisional application: 10161132.5
(73) Proprietor: ASML Netherlands B.V., 5504 DR Veldhoven (NL)
(72) Inventor: Van Haren, Richard Johannes Franciscus, 5501 DT Veldhoven (NL); Van Hinnen, Paul Christiaan, 5506 AW Veldhoven (NL); Lalbahadoersing, Sanjay, 5709 KZ Helmond (NL); Megens, Henry, 5612 RR Eindhoven (NL); Van der Schaar, Maurits, 5508 PA Veldhoven (NL)
(74) Representative: van Os, Lodewijk Hubertus

(56) References cited:
- US-A1- 2002 001 761
- US-B1- 6 420 791
- P. HINNEN ET AL.: "Advances in Process Overlay" PROCEEDINGS OF THE SPIE, vol. 4344, 2001, pages 114-126, XP002512241
- HUIJBREGTSE J ET AL: "Overlay Performance with Advanced ATHENA Alignment Strategies" PROCEEDINGS OF THE SPIE,, vol. 5038, 1 January 2003 (2003-01-01), pages 918-928, XP002511747
- G. RIVERA ET AL.: "Overlay Performance on Tungsten CMP Layers Using the ATHENA Alignment System" PROCEEDINGS OF THE SPIE, vol. 3998, 2000, pages 428-440, XP002512242
- S. WARRICK ET AL.: "Integration of New Alignment Mark Designs in Dual Inlaid Copper Interconnect Processes" PROCEEDINGS OF THE SPIE, vol. 4691, July 2002 (2002-07), pages 971-980, XP002512243

## Description

### Field of the invention

The present invention relates to a marker structure as defined in the preamble of claim 1, a lithographic projection apparatus comprising a device for wafer alignment which uses said marker structure, and a method for wafer alignment using said marker structure.

### Background of the invention

The present invention finds an application in the field of lithographic projection apparatus that encompass a radiation system for supplying a projection beam of radiation, a support structure for supporting patterning means, which serves to pattern the projection beam according to a desired pattern, a substrate table for holding a substrate; and, a projection system for projecting the patterned beam onto a target portion of the substrate.

The term "patterning means" as employed here should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmission mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a visco-elastic control layer and a reflective surface. The basic principle behind such an apparatus is that (for example) addressed areas of the reflective surface reflect incident light as diffracted light, whereas unaddressed areas reflect incident light as non-diffracted light. Using an appropriate filter, the said non-diffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localised electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described here above, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as set forth here above.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallisation, oxidation, chemical-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens".

Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

For a lithographic process an alignment of the wafer to be processed with the mask pattern on the mask should be as precise as possible for a correct definition of features on the substrate, which features all should have sizes within specified tolerances. To this end, the lithographic projection apparatus comprises a wafer alignment module which provides for alignment of the substrate with the mask and mask pattern within a given (specified) tolerance. The wafer alignment system typically performs the alignment based on optical means. The position of a wafer or a portion of a wafer is determined by measuring an optical response from an optical marker which is illuminated by an optical source: for example, a grating is illuminated by a laser beam, the laser beam diffracts from the grating, and one or more of the diffracted orders are measured by respective sensors, which are typically located on a reference plane. Using the output of the sensors the position of the wafer can be derived (relative to the reference plane).

In the prior art optical markers comprise a grating with a periodicity suitable for diffraction of impinging light with a wavelength well within the visible range of the spectrum. A typical periodicity is 16 µm. The grating is typically constructed of lines and trenches. Typically, the line width and trench width are each 8 µm. In order to obtain sufficient diffracted light from the grating and to obtain well-defined diffraction maxima and minima, the grating must encompass a minimal number of lines and intermediate trenches. The size in the direction of the periodic structure is about 750 µm.

The grating may be a phase grating or phase marker which takes into account a phase difference between the phase of rays scattered at the upper surface of the grating and the phase of rays scattered at the lower surface of the grating.

Also, the grating may be an amplitude grating which only takes into account the periodic structure of the grating without any further phase difference relating to an upper or lower level in the grating. Typically, an amplitude grating or amplitude marker is constructed of a periodic structure of first and second elements, which have similar surface levels but different respective reflectance.

Optical markers are used during microelectronic device processing (or IC processing) along the full manufacturing line. During the front end of line (FEOL), markers are used for alignment during manufacturing of transistor structures. At a later stage during the back end of line (BEOL), markers are needed for alignment of metallisation structures, e.g. connect lines, and vias. It is noted that in both cases the integrity of the markers must be sufficient to meet the required accuracy of alignment.

During semiconductor manufacturing processes a wafer is subjected to a plurality of treatments such as annealing, etching, polishing, etc., which may likely cause roughness of a marker (a recessed area in the marker and/or warping of the marker). Such marker roughness causes an alignment error of the image which may contribute to an overlay error in the construction of a semiconductor device. Also, it is conceivable that during the subsequent stages of processing the quality of markers tend to diminish.

A disadvantage of prior art optical markers is that during IC processing it is difficult to control the phase depth of the optical marker. As a result, the intensity of diffracted light under a given diffraction angle may be low and even close to zero, and accurate measurement of the diffracted beam may be difficult or even impossible. The phase depth can be defined as the resolved height difference between a top surface of a line and a top surface of a trench in a grating under a given angle of diffraction. If under an angle of diffraction, where (under optimal conditions) a maximum of diffracted intensity is expected, the phase depth equals half a wavelength of the applied radiation, interference between diffracted waves will result in a low or zero intensity.

Control of the phase depth during IC processing may be difficult due to process variations from wafer to wafer, and also across a single wafer.

A further disadvantage of prior art markers results from the dependence of marker properties as a function of the layer(s) below the marker. It is known that due to different optical behaviour of the various layers, as found in semiconductor devices, the contrast of the marker may vary, which results in variations of the diffracted intensity as function of the layer below.

Moreover, it is known that various processing steps may adversely influence the shape of alignment markers. Due to the effect on the shape, the alignment by such modified markers may comprise an error which can result from the fact that the modified shape of the marker changes the generated (pattern of) diffracted beams.

Furthermore, in the prior art, during BEOL processing, optical markers could be detected under capping layers by virtue of the residual structure which was visible at the surface. However, due to application of planarisation processes such as chemical mechanical polishing (CMP), the option to use a residual marker structure for alignment in many cases has become impossible.

In the prior art, markers on a semiconductor substrate that comprise trenches filled with tungsten, are subjected to a CMP process for removing tungsten from the surface and planarising the surface. Due to the CMP process the tungsten structures are either filled or underfilled. The extent of filling is related to the phase depth of an optical signal generated by the marker, i.e., two discrete phase depth levels exist. One level relates to filled tungsten structures which are shallow and have a small phase depth, the other level relates to underfilled tungsten structures which are relatively deep and have a large phase depth. Small phase depth of the filled markers is undesirable since the alignment error caused by the small phase depth is relatively large. Also, the large phase depth does not guarantee that the alignment error is reduced: the phase depth may be such that extinction of the optical signal results. Furthermore, no control over the phase depth is obtained.

The influence of optical markers on IC processing may lead to undesirable side effects due to the fact that the optical markers are inherently larger than feature sizes in integrated circuits. In the prior art the minimum feature size of markers is in the order of 1 µm. In current microelectronic devices, the typical minimal feature size is about 100 nm (depending on the device generation). Since the marker usually consists of the same material as (part of) the devices, the presence of an additional marker area of a substantial size in the vicinity of a device may have an influence on the local processing rate for that device in a given processing step. For example, a chemical reaction in a reactive ion etching process or a chemical deposition process may be influenced by the presence of a large marker area due to some kinetic constraint, or due to a local deviation of the wafer temperature, etc. A size difference between marker and device feature may thus lead, for example, to modification of a processing step for devices located closely to a marker. Due to the modification of the processing a variation of device characteristics may occur across a die and/or a wafer.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The person skilled in the art will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and " projection beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm).

US 6420791B and XP 2512241 disclose a marker structure comprising a metal grating in a dielectric layer and a metal plateau formed in a second lower dielectric layer, the two dielectric layers being separated by a third dielectric layer.

### Summary of the invention

It is an object of the present invention to provide a marker structure that allows correction of the phase depth in such a way that negative interference within the diffraction pattern is prevented.

In a first aspect of the present invention, this object is achieved in a marker structure on a substrate for optical alignment of the substrate as defined in the preamble of claim 1, characterised in that a recess (R1; R2; R3) is present in said second reflecting surface to modify said phase condition.

The recessed area changes the phase depth by an amount that a positive interference between with sufficient intensity is seen at the sensor.

Moreover, it is an object of the present invention to provide a lithographic projection apparatus which allows application of the marker structure as described above.

Furthermore, it is an object of the present invention to provide methods of alignment of a substrate in a lithographic projection apparatus which uses the marker structures as described above.

### Brief description of drawings

Below, the invention will be explained with reference to some drawings, which are intended for illustration purposes only and not to limit the scope of protection as defined in the accompanying claims.
Figure 1 depicts a lithographic projection apparatus comprising at least one marker structure according to the present invention;
Figure 2 schematically shows a cross-sectional view of a prior art marker structure to illustrate the concept of phase depth;
Figure 3a schematically shows a cross-sectional view of a marker structure from the prior art in copper-damascene layers;
Figure 3b a cross-sectional view of a first embodiment of a marker structure according to the present invention:
Figure 3c a cross-sectional view of a second embodiment of a marker structure according to the present invention;
Figure 4 schematically shows a cross-sectional view of a third embodiment of a marker structure.

### Description of embodiments

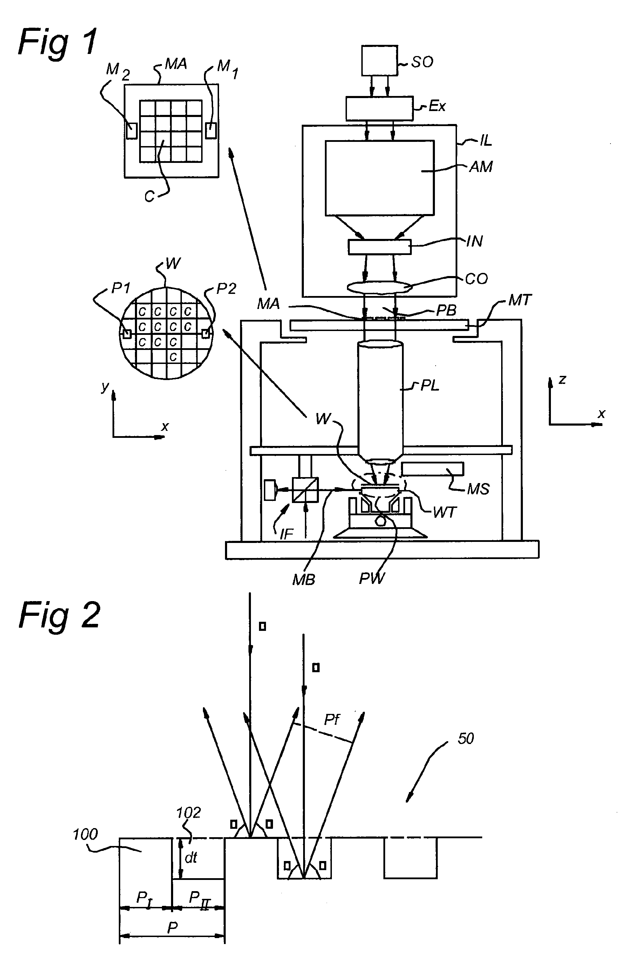

Figure 1 schematically depicts a lithographic projection apparatus 1 comprising at least one marker structure according to a particular embodiment of the invention. The apparatus comprises:
- a radiation system Ex, IL, for supplying a projection beam PB of radiation (e.g. UV radiation). In this particular case, the radiation system also comprises a radiation source SO;
- a first object table (mask table) MT provided with a mask holder for holding a mask MA (e.g. a reticle), and connected to first positioning means (not shown) for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL for imaging an irradiated portion of the mask MA onto a target portion C (e.g. comprising one or more dies) of the substrate W.

As here depicted, the apparatus is of a transmissive type (i.e. has a transmissive mask). However, in general, it may also be of a reflective type, for example (with a reflective mask). Alternatively, the apparatus may employ another kind of patterning means, such as a programmable mirror array of a type as referred to above.

The source SO (e.g. a mercury lamp or an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the source SO may be within the housing of the lithographic projection apparatus (as is often the case when the source SO is a mercury lamp, for example), but that it may also be remote from the lithographic projection apparatus, the radiation beam which it produces being led into the apparatus (e.g. with the aid of suitable directing mirrors); this latter scenario is often the case when the source SO is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW and interferometric measuring means, the substrate table WT can be moved accurately, e.g. so as to position different target portions C in the path of the beam PB. Similarly, the first positioning means (acting on mask table MT) can be used to accurately position the mask MA with respect to the path of the beam PB, e.g. after mechanical retrieval of the mask MA from a mask library, or during a scan. In general, movement of the object tables MT, WT will be realised with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the X and/or Y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the Y-direction) with a speed v, so that the projection beam PB is caused to scan over a mask image; concurrently, the substrate table WT is simultaneously moved in the same or opposite direction at a speed V = M v, in which M is the magnification of the lens PL (typically, M = 1/4 or 1/5). In this manner, a relatively large target portion C can be exposed, without having to compromise on resolution.

The interferometric measuring means typically can comprise a light source, such as a laser (not shown), and one or more interferometers for determining some information (e.g., position, alignment, etc.) regarding an object to be measured, such as a substrate or a stage. In Figure 1, for example, one interferometer IF is schematically depicted. The light source (laser) produces a metrology beam MB which is routed to the interferometer IF by one or more beam manipulators. In case more than one interferometer is present, the metrology beam is shared between them, by using optics that split the metrology beam in various separate beams for each interferometer.

A substrate alignment system MS for alignment of a substrate on table WT with the mask MA on mask table MT, is schematically shown at an exemplary location close to substrate table WT, and comprises at least one light source which generates a light beam aimed at a marker structure on the substrate and at least one sensor device which detects an optical signal from that marker structure. It is noted that the location of the substrate alignment system MS depends on design conditions which may vary with the actual type of lithographic projection apparatus. The marker structures may be for example substrate alignment marks P1, P2.

Figure 2 schematically shows a cross-sectional view of a prior art marker structure to illustrate the concept of phase depth.

An optical marker structure typically comprises a grating 50 with a periodicity P suitable for diffraction of impinging light with a wavelength λ. Where the term "light" is used in the present document, it is not limited to wavelengths within the visible spectrum but may encompass light of longer wavelength or shorter wavelength than visible wavelengths. It will be appreciated that it is not essential that the periodicity P be suitable for diffraction of light within the visible spectrum, and that the invention can be implemented with a periodicity P suitable for shorter wavelengths or suitable for longer wavelengths.

The grating consists of a series of lines 100, with interposed trenches 102. The trenches 102 have a depth dₜ with respect to the top surface of the lines 100. The periodicity P of the grating is composed of a line width P_{I} and a trench width P_{II}.

In Figure 2, an impinging light beam λ is directed in a direction substantially perpendicular to the surface of the substrate. Alternatively, a non-perpendicular inclination of the impinging beam may be used.

The marker grating from the prior art is a so-called phase grating. A diffraction pattern is schematically shown by two diffracted beams, each having a diffraction angle θ relative to the surface.

In the diffraction pattern the position of intensity maxima and minima is governed by the periodicity of the grating. When the wavelength λ of the impinging light is within the range of visible light, periodicity P may typically be 16 µm to obtain a diffraction pattern suitable for purpose of alignment. Typically, the line width P_{I} and trench width P_{II} are each 8 µm.

In order to obtain sufficient diffracted light from the grating 50 and to obtain an angular distribution (a diffraction pattern) of well-defined diffraction maxima and minima, the grating 50 must encompass a minimal number of lines 100 and intermediate trenches 102 which are illuminated by the impinging light beam. In the prior art a marker comprises at least 10 trenches within the illuminated area.

The intensity of the diffracted beams is further determined by the depth dₜ of the trenches 102 relative to the top surface of the lines 100. In a certain direction of diffracted light, the light rays scattered at the top surface of the lines 100 and the light rays scattered at the bottom of the trenches 102 must have a certain phase relation to obtain a positive interference between these light rays in that direction, independent from the periodicity P. The depth dₜ of the trenches 102 relative to the surface of the lines 100 must be such that positive interference will occur. If the interference is negative, an extinction of the signal will occur. This is known as the phase depth condition.

In the phase grating 50 the interference in the diffraction pattern can be schematically deduced as follows: under angle θ a first set of photons reflect on the top surfaces of the lines 100, while a second set of photons reflect at the floor of the trenches 102. In order to determine if in a given direction, indicated by diffraction angle θ, an intensity maximum or minimum will occur, the phase difference of photons originating from the line top surfaces and from the trench floors must be substantially zero or half a wavelength, respectively, at the propagation front PF.

For an optical marker structure on a semiconductor wafer, the structure may be exposed to various deformations during the processing steps of the semiconductor wafer to form integrated circuits. Due to these deformations the phase depth dₜ may change during manufacturing.

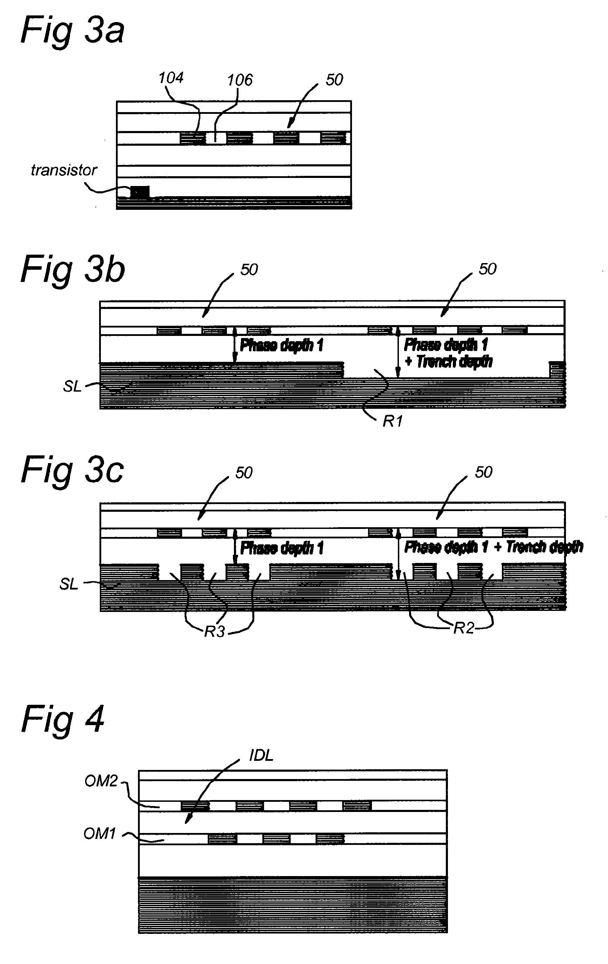

Figure 3a schematically shows a cross-sectional view of a marker structure from the prior art. In Figure 3a, an optical marker structure OM on a substrate layer SL is shown which may be applied in back end of line (BEOL) IC processes for Cu-based microelectronic devices. Such devices are typically manufactured by so-called Cu damascene process technology, wherein copper structures are embedded in (optically transparent) dielectric material, appearing as a "floating marker". The optical marker 50 consists of a plurality of Cu line elements 104, embedded in dielectric material, wherein the dielectric material is shaped as a plurality of line elements 106. Typically, as known to persons skilled in the art, the dielectric material may consist of a stack of various separate dielectric layers. By consequence, the phase depth dₜ of the marker 50 may be ill-defined due to variations in the thickness of various separate dielectric layers in the dielectric stack. Moreover, variations may exist across a die or a wafer. Thus, in a worst case, the intensity of the marker's signals as included in the diffraction pattern may be too weak for detection by the alignment tool. This may result in a marker reject or even a wafer reject during IC processing.

Figure 3b shows a cross-sectional view of a first embodiment of a marker structure according to the present invention.

A way to avoid extinction due to an incompatible phase depth is shown in Figure 3b. In Figure 3b entities with the same reference number refer to the same entities as shown in figure 3a. In the area of the semiconductor substrate (or in general an opaque layer) SL under the floating marker 50, a recess R1 is created in front end of line (FEOL) process. This recess increases the phase depth and thus reduces the probability of negative interference between scattered light from the surface level and the level of the substrate or opaque layer.

As shown in Figure 3b the recess may be formed only under a portion of area covered by the floating marker 50, in which case two different phase depths are present one of which may yield a better usable diffraction signal of sufficient intensity.

Figure 3c shows a cross-sectional view of a second embodiment of a marker structure according to the present invention.

In the second embodiment, the recessed area is defined during a FEOL process only below a portion of the marker 50. As indicated in the right-hand side of Figure 3c, recesses R2 are formed only below the transparent portions of the marker 50. In the left-hand side of Figure 3c a recessed area R3 is formed only below the opaque portions of the marker 50. Again, two different phase depths are present, each of which may yield a usable diffraction signal of sufficient intensity.

It is noted that such a recessed area R2, R3 may be formed by using the mask of the marker and an appropriate lithographic process, with a positive or negative exposure, respectively.

The recessed area as shown in Figure 3b or 3c preferably adds about 200 - 300 nm to the phase depth.

Figure 4 schematically shows a cross-sectional view of a third embodiment of a marker structure.

A further disadvantage of prior art markers is due to the dependence of marker properties as a function of the layer(s) below the marker. It is known that due to different optical behaviour of the various layers, as found in semiconductor devices, the contrast of the marker may vary, which results in variations of the diffracted intensity as function of the layer below, i.e. the phase depth strongly varies as a function of the under-lying layer.

In the third embodiment, the phase depth is better controlled by defining a first optical marker OM1 in a first metal layer (by exposure and processing) in a first ordering tone, i.e., a given periodic repetition of a first structural element and a second structural element. Next, in a second metal layer stacked on the first one with at least one intermediate dielectric layer IDL, a second optical marker OM2 with the same first ordering tone but in reverse tone relative to the first marker, is defined (exposed and processed). The reverse tone indicates that the second marker OM2 comprises the same periodic repetition as the first optical marker OM1, but the locations of the first structural element and the second structural element are exchanged relative to the first marker OM1.

By control of the intermediate dielectric layer IDL the phase depth can be controlled: i.e., a phase depth value is selected which yields a diffraction signal of sufficient intensity. Moreover, the space occupied by the markers within a scribelane of the wafer is strongly reduced by stacking optical markers.

It is noted that the thickness of IDL is usually determined by the IC processing parameters. If, accidentally, the thickness of IDL between the stacked markers corresponds to a phase depth which causes negative interference for a wavelength used by the substrate alignment system, a second wavelength may be used.

## Claims

1. Marker structure on a substrate for optical alignment of said substrate, said marker structure comprising:
a plurality of first structural elements and a plurality of second structural elements;
said first structural element having a first reflecting surface on a first level, said second structural element being substantially non-reflecting;
a second reflecting surface located on a second lower level;
a separation between said first and second reflecting surfaces determining a phase depth condition for said detected light,
in use said marker structure allowing said optical alignment based upon
- providing at least one light beam directed on said marker structure,
- detecting light received from said marker structure at a sensor,
- determining alignment information from said detected light, said alignment information comprising information relating a position of said substrate to said sensor;
said marker structure being **characterised in that** a recess (R1; R2; R3) is present in said second reflecting surface to modify said phase condition.

2. Marker structure according to claim 1, wherein said first and said second structural elements are arranged to form a diffraction grating, said first structural elements being lines (104) of said grating and said second structural elements being spaces (106) of said grating.

3. Marker structure according to claim 1 or claim 2, wherein said first structural element comprises a metal.

4. Marker structure according to any of claims 1 to 3, wherein said second structural element comprises a dielectric.

5. Marker structure according any of the preceding claims, wherein said recess is present under a portion of said marker structure.

6. Marker structure according to any one of the preceding claims, wherein said recess (R2) is created as a partial recess, said partial recess substantially being located under each of said second structural elements.

7. Marker structure according to any of claims 1 to 6, wherein said recess (R3) is created as a partial recess, said partial recess substantially being located under each of said first structural elements.

8. Marker structure according to any of claims 2 to 7, wherein said metal is copper.

9. A substrate for microelectronic devices comprising at least one marker structure according to any one of the preceding claims 1-8.

10. A lithographic projection apparatus comprising:
- a radiation system for providing a projection beam of radiation;
- a support structure for supporting patterning means, the patterning means serving to pattern the projection beam according to a desired pattern;
- a substrate table (WS) for holding a substrate;
- a projection system for projecting the patterned beam onto a target portion of the substrate;
- a substrate alignment system (MS) for detecting a position of said substrate relative to a position of said patterning means;
- said substrate comprising at least one marker structure according to any one of the claims 1-8.

11. Method of alignment of a substrate in a lithographic projection apparatus comprising:
- a radiation system for providing a projection beam of radiation;
- a support structure for supporting patterning means, the patterning means serving to pattern the projection beam according to a desired pattern;
- a substrate table (WS) for holding a substrate;
- a projection system for projecting the patterned beam onto a target portion of the substrate;
- a substrate alignment system (MS) for detecting a position of said substrate relative to a position of said patterning means;
said method comprising:
- providing at least one light beam directed on a marker structure according to any one of the claims 1-8.

## Patentansprüche

1. Eine Markierungsstruktur auf einem Substrat zur optischen Justierung des Substrats, wobei die Markierungsstruktur Folgendes beinhaltet:
eine Vielzahl von ersten strukturellen Elementen und eine Vielzahl von zweiten strukturellen Elementen;
wobei das erste strukturelle Element eine erste reflektierende Oberfläche auf einem ersten Niveau aufweist, wobei das zweite strukturelle Element im Wesentlichen nicht reflektierend ist;
eine zweite reflektierende Oberfläche, die sich auf einem zweiten, tieferen Niveau befindet;
eine Trennung zwischen der ersten und der zweiten reflektierenden Oberfläche, die eine Phasentiefenbedingung für das erfasste Licht bestimmt;
wobei die Markierungsstruktur bei Verwendung die optische Justierung basierend auf dem Folgenden ermöglicht:
- Bereitstellen mindestens eines Lichtstrahls, der auf die Markierungsstruktur gerichtet ist,
- Erfassen von Licht, das an einem Sensor von der Markierungsstruktur empfangen wird,
- Bestimmen von Justierinformationen aus dem erfassten Licht, wobei die Justierinformationen Informationen beinhalten, die dem Sensor eine Position des Substrats vermitteln;
wobei die Markierungsstruktur **dadurch gekennzeichnet ist, dass** in der zweiten reflektierenden Oberfläche eine Aussparung (R1; R2; R3) vorhanden ist, um die Phasenbedingung zu modifizieren.

2. Markierungsstruktur gemäß Anspruch 1, wobei die ersten und zweiten strukturellen Elemente eingerichtet sind, um ein Beugungsgitter zu bilden, wobei die ersten strukturellen Elemente Linien (104) des Gitters sind und die zweiten strukturellen Elemente Zwischenräume (106) des Gitters sind.

3. Markierungsstruktur gemäß Anspruch 1 oder Anspruch 2, wobei das erste strukturelle Element ein Metall beinhaltet.

4. Markierungsstruktur gemäß einem der Ansprüche 1 bis 3, wobei das zweite strukturelle Element ein Dielektrikum beinhaltet.

5. Markierungsstruktur gemäß einem der vorhergehenden Ansprüche, wobei die Aussparung unter einem Abschnitt der Markierungsstruktur vorhanden ist.

6. Markierungsstruktur gemäß einem der vorhergehenden Ansprüche, wobei die Aussparung (R2) als eine Teilaussparung kreiert ist, wobei sich die Teilaussparung im Wesentlichen unter jedem der zweiten strukturellen Elemente befindet.

7. Markierungsstruktur gemäß einem der Ansprüche 1 bis 6, wobei die Aussparung (R3) als eine Teilaussparung kreiert ist, wobei sich die Teilaussparung im Wesentlichen unter jedem der ersten strukturellen Elemente befindet.

8. Markierungsstruktur gemäß einem der Ansprüche 2 bis 7, wobei das Metall Kupfer ist.

9. Ein Substrat für mikroelektronische Vorrichtungen, das mindestens eine Markierungsstruktur gemäß einem der vorhergehenden Ansprüche 1-8 beinhaltet.

10. Ein lithographisches Projektionsgerät, das Folgendes beinhaltet:
- ein Strahlungssystem zum Bereitstellen eines Projektionsstrahls aus Strahlung;
- eine Stützstruktur zum Stützen eines Musteraufbringungsmittels, wobei das Musteraufbringungsmittel dazu dient, den Projektionsstrahl gemäß einem gewünschten Muster zu mustern;
- einen Substrattisch (WS) zum Halten eines Substrats;
- ein Projektionssystem zum Projizieren des gemusterten Strahls auf einen Zielabschnitt des Substrats;
- ein Substratjustiersystem (MS) zum Erfassen einer Position des Substrats in Bezug auf eine Position des Musteraufbringungsmittels;
- wobei das Substrat mindestens eine Markierungsstruktur gemäß einem der Ansprüche 1-8 beinhaltet.

11. Ein Verfahren zur Justierung eines Substrats in einem lithographischen Projektionsgerät, das Folgendes beinhaltet:
- ein Strahlungssystem zum Bereitstellen eines Projektionsstrahls aus Strahlung;
- eine Stützstruktur zum Stützen eines Musteraufbringungsmittels, wobei das Musteraufbringungsmittel dazu dient, den Projektionsstrahl gemäß einem gewünschten Muster zu mustern;
- einen Substrattisch (WS) zum Halten eines Substrats;
- ein Projektionssystem zum Projizieren des gemusterten Strahls auf einen Zielabschnitt des Substrats;
- ein Substratjustiersystem (MS) zum Erfassen einer Position des Substrats in Bezug auf eine Position des Musteraufbringungsmittels;
wobei das Verfahren Folgendes beinhaltet:
- Bereitstellen mindestens eines Lichtstrahls, der auf eine Markierungsstruktur gemäß einem der Ansprüche 1-8 gerichtet ist.

## Revendications

1. Structure de marqueur sur un substrat destinée à l'alignement optique dudit substrat, ladite structure de marqueur comprenant :
une pluralité de premiers éléments structurels et une pluralité de deuxièmes éléments structurels ;
ledit premier élément structurel ayant une première surface réfléchissante sur un premier niveau, ledit deuxième élément structurel étant substantiellement non réfléchissant ;
une deuxième surface réfléchissante se trouvant sur un deuxième niveau, plus bas ;
une séparation entre lesdites première et deuxième surfaces réfléchissantes déterminant une condition de profondeur de phase pour ladite lumière détectée,
en utilisation, ladite structure de marqueur permettant ledit alignement optique en s'appuyant sur
- la fourniture d'au moins un faisceau de lumière dirigé sur ladite structure de marqueur,
- la détection de la lumière reçue de ladite structure de marqueur au niveau d'un capteur,
- la détermination d'informations d'alignement à partir de ladite lumière détectée, lesdites informations d'alignement comprenant des informations situant une position dudit substrat par rapport audit capteur ;
ladite structure de marqueur étant **caractérisée en ce qu'**un renfoncement (R1 ; R2 ; R3) est présent dans ladite deuxième surface réfléchissante afin de modifier ladite condition de phase.

2. Structure de marqueur selon la revendication 1, dans laquelle lesdits premiers et lesdits deuxièmes éléments structurels sont agencés afin de former un réseau de diffraction, lesdits premiers éléments structurels étant des lignes (104) dudit réseau et lesdits deuxièmes éléments structurels étant des espaces (106) dudit réseau.

3. Structure de marqueur selon la revendication 1 ou la revendication 2, dans laquelle ledit premier élément structurel comprend un métal.

4. Structure de marqueur selon n'importe lesquelles des revendications 1 à 3, dans laquelle ledit deuxième élément structurel comprend un diélectrique.

5. Structure de marqueur selon n'importe lesquelles des revendications précédentes, dans laquelle ledit renfoncement est présent sous une portion de ladite structure de marqueur.

6. Structure de marqueur selon l'une quelconque des revendications précédentes, dans laquelle ledit renfoncement (R2) est créé comme un renfoncement partiel, ledit renfoncement partiel se trouvant substantiellement sous chacun desdits deuxièmes éléments structurels.

7. Structure de marqueur selon n'importe lesquelles des revendications 1 à 6, dans laquelle ledit renfoncement (R3) est créé comme un renfoncement partiel, ledit renfoncement partiel se trouvant substantiellement sous chacun desdits premiers éléments structurels.

8. Structure de marqueur selon n'importe lesquelles des revendications 2 à 7, dans laquelle ledit métal est le cuivre.

9. Un substrat destiné à des dispositifs microélectroniques comprenant au moins une structure de marqueur selon l'une quelconque des revendications précédentes 1 à 8.

10. Un appareil de projection lithographique comprenant :
- un système de rayonnement destiné à fournir un faisceau de projection de rayonnement ;
- une structure formant support destinée à supporter un moyen pour conformer selon un motif, le moyen pour conformer selon un motif servant à conformer le faisceau de projection selon un motif souhaité ;
- une table porte-substrat (WS) destinée à porter un substrat ;
- un système de projection destiné à projeter le faisceau à motif sur une portion cible du substrat ;
- un système d'alignement de substrat (MS) destiné à détecter une position dudit substrat relativement à une position dudit moyen pour conformer selon un motif ;
- ledit substrat comprenant au moins une structure de marqueur selon l'une quelconque des revendications 1 à 8.

11. Procédé d'alignement d'un substrat dans un appareil de projection lithographique comprenant :
- un système de rayonnement destiné à fournir un faisceau de projection de rayonnement ;
- une structure formant support destinée à supporter un moyen pour conformer selon un motif, le moyen pour conformer selon un motif servant à conformer le faisceau de projection selon un motif souhaité ;
- une table porte-substrat (WS) destinée à porter un substrat ;
- un système de projection destiné à projeter le faisceau à motif sur une portion cible du substrat ;
- un système d'alignement de substrat (MS) destiné à détecter une position dudit substrat relativement à une position dudit moyen pour conformer selon un motif ;
ledit procédé comprenant :
- la fourniture d'au moins un faisceau de lumière dirigé sur une structure de marqueur selon l'une quelconque des revendications 1 à 8.
